# EUROPEAN PATENT APPLICATION

(11) **EP 2 362 721 A1**
(43) Date of publication of application: **31.08.2011**
(21) Application number: 10154870.9
(22) Date of filing: 26.02.2010
(51) Int. Cl.: H05K 7/20

(54) **Method and system for cooling apparatus racks**

(71) Applicant: TeliaSonera AB, 10663 Stockholm (SE)
(72) Inventor: Enlund, Svante, S-133 43, Saltsjöbaden (SE)
(74) Representative: Partio, Erja

(57) **Abstract**

The invention relates to a system and method that comprises at least two parallel apparatus racks and at least two cooling units. The cooling units are configured to produce horizontal cooled airflows toward outer sides of the at least two apparatus rack. The cooling units comprise an upper side inlet for airflow to be cooled. The system and method achieve a more effective cooling of apparatus racks.

## Description

### BACKGROUND OF THE INVENTION

### Field of the invention:

The invention relates to cooling. Particularly, the invention relates to a method and a system for cooling apparatus racks, especially with high heat loads.

### Description of the Related Art:

Apparatus racks are used to house interrelated electronic or otherwise functional devices with a similar or related heat dissipation function. The electronic devices may represent stripped down versions of devices such as a computers that might otherwise be provided with a separate housing or cover. The devices are usually connected with an electrical connection. The racks are usually provided with shared power units and in some cases shared fan trays. The electronic devices are typically computer units comprising microprocessors, memory circuits and hard disc units. Also other devices producing heat loads may be installed into an apparatus rack. A rack may typically comprise a conventional horizontally mounted server, vertically mounted blade server or a telecommunications network element. By a rack may be meant a single rack with a number of stacked mounting frames or a number of separate adjacent racks. A typical rack width has during many years been 19 inches , but many other rack sizes also exist varying in height, depth or width.

A problem of apparatus racks is the production of heat typically by computer units and electrical cables. In data centers it is not economical to space the computer units with a sufficient distance from one another to get rid of active cooling. Data centers are typically high security environments, which may be located under ground level or may have other means for added security. This increases the cost of a data center's floor space significantly.

The heat load of a single rack has increased over the past years from typical 1...3 kW to 15...25 kW and over. As a result, demands for continuous cooling for an individual rack have increased, as well as demands for redundancy continuous services and quality of service. Abnormal hot spots in a rack mounted device may lead to breakage of the device or to reduced service level.

The racks are may be provided with fan trays or fans placed on electronic device plug-in units in order to disperse heat from the equipment on the rack. The fans distribute heat to the data center atmosphere, but in order to actually cool down the temperature of the data centers, they are usually built over a raised floor, below which there is provided a pressurized cooled airflow. The floor has small evenly spaced holes to get an upward cooling airflow to the data center space. The raised floor also permits the cabling to be hidden.

A common solution for controlling the data center temperature is a computer room air conditioning (CRAC) unit, comprising air conditioning means and fans to circulate air in the room. CRAC unit monitors and maintains data center's temperature, air distribution and humidity. CRAC units may be situated in the data center by cooling air and dispensing it through a raised floor or they may be arranged to cool freely circulating air in the data center.

EP958720B1 discloses a cooling unit that enables a laminar cooled air flow from the unit towards the equipment, so that no warm surrounding air is mixed into the air flow.

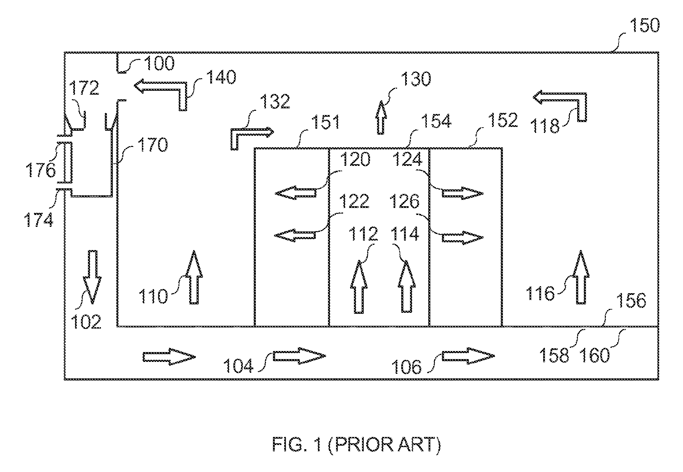

A reference is now made to Figure 1, which illustrates a cooling system of a data center in prior art. In Figure 1 there is illustrated a data center space 150. Data center space 150 contains a first rack row 151 and a second rack row 152, which are separated by a space. The data center has a raised floor 156 with openings such as 158 and 160 throughout its entire area. Through an inlet 100 there is received airflow 140 from the data center space 150. The airflow is blown via an air conditioning unit 270, which as an inlet 176 and an outlet 174 for external air or cooling water supply. The external air or cooling water is cooled in an external space such as outside air. Cooled air exits air conditioning unit 170 as illustrated with arrow 102. Cooled air is led to space below raised floor 156, as illustrated with arrows 104 and 106. Cooled air enters data center space 150 that contains the racks via openings in floor 156, as illustrated with arrows 110 - 116. Cooled air travels ineffectively through rack rows 151 and 152, as illustrated with arrows 120 - 126. The cooled air travelling directly upwards is illustrated with arrow 130. In order to increase the flow of cooled air horizontally via rack rows 151 and 152, the intervening space may be covered with a cover 154 that forces air through rack rows 151 and 152. Further air flow directions are illustrated with arrows 118 and 132. Generally, air that has accumulated heat travels upward and from there it is obtained toward inlet 100.

Usually computer racks in a data center are arranged in a hot/cold aisle layout. Hot aisle/cold aisle data center arrangement involves lining up computer racks in alternating rows so that cold air intakes face one way and hot air exhausts face the other way. The rows composed of rack fronts are called cold aisles. Typically, cold aisles face air conditioner output ducts. The aisles that the heated exhausts pour into are called hot aisles. Typically, hot aisles face air conditioner return ducts.

The problem in existing cooling system such as illustrated in Figure 1 is the power consumption required to keep the racks at a sufficiently low temperature. The temperature loss between coolant fluid and inlet air-to-equipment is high, typically between 10...20 degrees Celsius. This creates high requirements for the heat dissipation, for example, through secondary circuit and limits the free-cooling period severely. Ambient temperatures outside are limited to certain hours of the year within the temperature range. For that reason also environmentally unfriendly coolant refrigerants are more or less mandatory.

It would be beneficial to be able to reduce the power consumption, which leads to significant annual cost savings for the operator of the data center. The problem is exacerbated by a more tight packing of circuit boards in apparatus racks typically in modern blade servers. Prior art cooling systems have been designed for a sparser furnishing of the racks and for mainframe computer systems.

Another problem of an arrangement as illustrated in Figure 1 is, that it is possible to mount a single device into the rack in a reverse manner, i.e. the air flow is directed opposite to the general hot aisle-cold aisle configuration. Since the floor is uniform in both sides of the rack, it is not immediately evident to the installer, which is the correct direction of the air flow and the correct direction to mount the device.

### SUMMARY OF THE INVENTION:

The invention relates to a method for cooling a device mounted to an apparatus rack, providing at least two parallel apparatus racks comprising at least one device mounted to said racks, providing at least two cooling units on outer sides of both said at least two parallel apparatus racks. According to the invention first cooled airflows are directed from both said at least two cooling units to respective outer sides of said at least two equipment racks wherein said airflows are substantially horizontal laminar airflows. Second airflows are received to inlets provided on top of both said at least two cooling units, said second airflows conveying heat from said at least two equipment racks.

In one embodiment of the invention is provided a first cover to separate a first cool air space between a first equipment rack and a first cooling unit from the hot air space between the first equipment rack and the second equipment rack. A second cover is provided to separate a second space between a second equipment rack and a second cooling unit from the hot air space between the first equipment rack and the second equipment rack. The hot air space may be extended from between the first and second equipment racks to the inlets of the cooling units.

In one embodiment of the invention at least two cooling units comprise respective cooling battery that dissipates heat to coolant fluid. The coolant fluid may be liquid or gas.

In one embodiment of the invention the space surrounding a device mounted to the rack inside the first or second apparatus rack is hindered from air flow, thereby forcing the laminar airflow to pass through the device. This enhances the cooling effect. The air flow may be hindered to only part of the rack, depending on the cooling requirements of an individual device mounted to the apparatus rack.

In one embodiment of the invention is formed two cold aisles and one hot aisle. This is made by arranging more than one cooling units to a row formation, arranging more than one apparatus racks to a row formation, said rows forming a cold aisle between cooling units and the apparatus racks and a hot aisle between two parallel apparatus racks. In this arrangement the hot aisle is located in the middle of apparatus racks and two cold aisles outside apparatus racks. Apparatuses may also be arranged as an apparatus wall, in which apparatuses are mounted in higher stacks, for example by arranging several stacks on top of each other. This arrangement can be combined with row formations, thereby extending the wall.

The invention relates also to a system for cooling a device mounted to an apparatus rack, comprising a first apparatus rack, a second apparatus rack in parallel with said first apparatus rack, at least one device mounted to said apparatus rack. According to the invention the system comprises a first cooling unit in parallel with said first apparatus rack, said first cooling unit being configured to produce a substantially horizontal laminar cooled airflow towards outer side of said first apparatus rack, said first cooling unit comprising an inlet in the upper part for an airflow to be cooled; and a second cooling unit in parallel with said second apparatus rack, said second cooling unit being configured to produce a substantially horizontal laminar cooled airflow towards outer side of said second apparatus rack, said second cooling unit comprising an inlet in the upper part for an airflow to be cooled. In one embodiment the first and the second cooling unit comprise a cooling battery that dissipates heat to a coolant fluid.

One embodiment of the invention comprises a first cover to separate a first cool air space between a first equipment rack and a first cooling unit from the hot air space between the first equipment rack and the second equipment rack; and a second cover to separate a second space between a second equipment rack and a second cooling unit from the hot air space between the first equipment rack and the second equipment rack.

By parallel is meant in this case substantially parallel, which may allow, for example, a mutual angle between the racks and at least one adjacent air cooling unit that is less than 30 degrees. Several similar cooling units and apparatus racks may be installed side-by-side, together forming uniform rows of each type of device. This installation creates aisles between the rows, between rows of cooling units and apparatus racks is a cold aisle and between apparatus racks is a hot aisle. Thereby in one embodiment of the invention there exists a hot aisle in the middle between the apparatus racks and two cold aisles between apparatus racks and cooling units.

In one embodiment of the invention, there is provided a line of air cooling units which has a mutual angle between the racks and at least one adjacent air cooling unit that is less than 30 degrees.

In one embodiment of the invention, the height of the air cooling unit is larger than the height of the at least one apparatus rack to be cooled. The rack to be cooled has a height that allows personnel to insert plug-in-unit to the rack.

In one embodiment of the invention, one side of the air cooling unit comprises at least one an outlet or opening for cooled airflow produced by at least one blower. The same side of the air cooling unit comprises above an evaporator an inlet or opening for obtaining air to be cooled. The height of the inlet or opening may be, for example, above 1600 mm measured from a floor supporting the air cooling unit in its upright position.

The invention relates also to a system for cooling a device mounted to an apparatus rack, comprising a first cooling unit, a first apparatus rack and at least one device mounted to said apparatus rack. According to the invention said first cooling unit is arranged in parallel with said first apparatus rack placed at a distance allowing maintenance work in the area between the first cooling unit and the first apparatus rack, said first cooling unit being configured to produce a substantially horizontal laminar cooled airflow, said airflow being evenly distributed over the side of first apparatus rack facing the first cooling unit. Cooling units produce the effect of a cool wall, where the horizontal laminar airflow appears to cover majority of the apparatus rack side facing the cooling unit. Arranging such cooling units to a row formation further enhances this cool wall effect.

In one embodiment the distance between the first cooling unit and the first apparatus rack is between 800 mm and 1400 mm. This arrangement, where the cooling unit and the apparatus rack are located close to each other enables better control of the airflow compared to turbulent airflow. The overall capacity is better supported by the cooling unit and it is easier to get more air directed to relevant parts. The practical distance between the rack and the cooling unit is defined by the ability to carry out maintenance work to devices in the rack or possibility to mount new devices into the rack.

The embodiments of the invention described hereinbefore may be used in any combination with each other. Several of the embodiments may be combined together to form a further embodiment of the invention. A method, a system or an air cooling unit to which the invention is related may comprise at least one of the embodiments of the invention described hereinbefore.

The benefits of the invention are related to the improved cooling of apparatus racks and reduction in power consumption. The horizontal, uniform airflow reduces the occurrence of hot spots inside a densely built apparatus rack.

The vertical cooling device gives better capacity than perforated floor. Open wall of the cooling device produces very little resistance to the air flow.

The effect of increased capacity enables the system to manage much higher heat loads with smaller coolant fluid temperature differences between the outlet and inlet of primary cooling circuit. For example to obtain a constant 22 degrees Celsius in the apparatus rack, the inlet fluid may be just 20 degrees Celsius. This enables the coolant fluid to be water or any other environmentally friendly material. Additionally the secondary cooling circuit may be cooled by outdoor air, chiller, or naturally flowing water from a river, lake or sea thereby increasingly reducing the overall costs of the data center cooling.

As the data center is well organized between two rows of cooling units, it is clear for the installer to know which aisle is the cool aisle and which aisle is the hot aisle. This reduces the risk of installing a device to a rack in a manner where its fan operates against the airflow.

Refurbishing existing data centers according to the present invention is easy. Cooling units can be positioned above the raised floor configuration or onto a normal solid floor. Using water or similar easily available cooling fluid leads to easy assembly.

### BRIEF DESCRIPTION OF THE DRAWINGS:

The accompanying drawings, which are included to provide a further understanding of the invention and constitute a part of this specification, illustrate embodiments of the invention and together with the description help to explain the principles of the invention. In the drawings:
**Fig. 1** illustrates a data center air conditioning system in prior art;
**Fig. 2** illustrates a system for cooling apparatus racks in one embodiment of the invention; and
**Fig. 3** is a flow chart illustrating a method for cooling apparatus racks in one embodiment of the invention.

### DETAILED DESCRIPTION OF THE EMBODIMENTS:

Reference will now be made in detail to the embodiments of the present invention, examples of which are illustrated in the accompanying drawings.

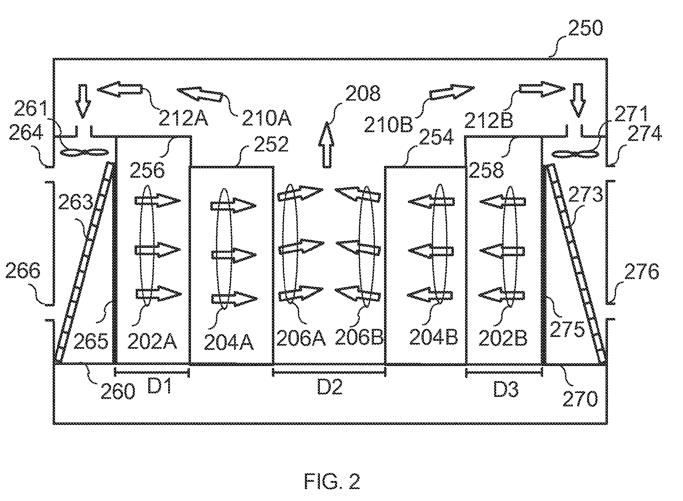

Figure 2 illustrates a system for cooling apparatus racks in one embodiment of the invention. The system comprises a first cooling unit 260 and a second cooling unit 270. The cooling units may be similar as common air conditioning units or CRAC units. An example of a preferred embodiment for a cooling unit suitable for the invention is disclosed in EP958720B1.

The cooling unit may also have a primary cooling circuit with internal cooling battery. The primary cooling circuit may be coupled to a secondary cooling circuit that dissipates the heat load by free cooling, chillers or to preferred location outside the data centre, such as to water from a river or to outdoor air. The secondary cooling circuit may be any system known to a skilled man in the art.

Cooling units 260 and 270 have respective primary cooling circuit inlets 264 and 274, and respective primary cooling circuit outlets 266 and 276. For example, an external cooling water supply may be provided. The external cooling water may be cooled by atmosphere air by way of the pipe system circulating outdoors or in a cooling pool.

The system is comprised in a room 250. Room 250 may have a raised floor to support cabling of racks such as server racks. Traditional raised floor cooling may also be used to support the cooling according to the present invention. The system also comprises at least a first apparatus rack 252 and a second apparatus rack 254. First rack 252 and second rack 254 are separated by a space, the width of which is represented in Figure 2 by D2. Similarly, the distance between first cooling unit 260 and first rack 252 is D1, whereas the distance between second cooling unit 270 and second rack 254 is D3. In one embodiment of the invention, distance D2 may be between 400 mm and 4000 mm, preferred distance may be between 800 and 1400 mm. Distances D1 and D3 must be sufficient to allow the management of racks 252 and 254 by personnel from both sides. In one embodiment of the invention, distances D1 and D3 may be may be between 400 mm and 4000 mm, preferred distance may be between 800 and 1400 mm. In one embodiment of the invention, more than two racks are placed in parallel between cooling units 260 and 270.

Cooling units 260 and 270 produce airflows 202A and 202B. Airflow is preferably uniform, the flow speed and direction is substantially laminar in between cooling units 260 and 270 and racks 252 and 252. Airflows 202A and 202B traverse racks 252 and 254 substantially horizontally, as illustrated with arrows 204A and 204B. Airflows exiting racks 252 and 254 are illustrated with arrows 206A and 206B, respectively. The airflows exiting racks 252 and 254 have a raised temperature and travel upward, as illustrated with arrow 208. The airflows meet in the space between racks 252 and 254 without carrying heat to the rack in opposite direction. Heated air is sucked to cooling units 260 and 270 by way of air circulation, as illustrated with arrows 210A, 210B, 212A and 212B.

Cooling units 260 and 270 comprise respective air fan assemblies 261 and 271 that provide air circulation from hot air space to cool air space. Cooling batteries 263 and 273 are used to dissipate heat to a coolant fluid. Cooling batteries 263 and 273 may be positioned diagonally inside cooling units 260 and 270, as seen in the cross-sectional view on Figure 2. In this arrangement cooling unit 260 and 270 is divided in a manner where the top section has more hot air space and lower section more cool air space. This arrangement provides more even air distribution to cool air space and enables the horizontal laminar flow. The effect is further enhanced by damping material plates 265 and 275 that reduce the turbulence present after cooling batteries 263 and 273 before laminar airflows 202A and 202B. In one embodiment of the invention, the cooling batteries 263 and 273 may also be spaced horizontally, vertically or in any position.

In one embodiment of the invention, between first rack 252 and first cooling unit 262 there is provided a cover 256. Similarly, between second rack 254 and second cooling unit 270 there is provided a cover 258. The purpose of covers 256 and 258 is to ensure direct airflow from cooling unit 260 and 270 towards racks 252 and 254, as illustrated with arrows 202A and 202B.

Cooling airflow effect may be further enhanced by closing apparatus racks between devices, allowing airflow to pass through devices installed in the rack. The airflow is hindered in a manner where the air flow can be further controlled and direct airflow according to different requirements of each device. For some devices it may be beneficial to allow part of the airflow to pass around the device, as some devices may cool better when the airflow goes through the device.

In one embodiment of the invention, racks 252 and 254 may comprise any number of adjacent rack modules that are placed substantially parallel in relation to each other in substantially straight rows. The distance between racks may vary slightly due to room support pillars or other blocks. Similarly, cooling units 260 and 270 may comprise any number of adjacent cooling modules placed substantially parallel in relation to each other in substantially straight rows. The distance between cooling units 260 and 270 may vary slightly due to room support pillars or other blocks.

In one embodiment of the invention, cooling units 260 and 270 may be comprised in substantially straight rows of cooling units that have a substantially even distance from racks.

In one embodiment of the invention, a single room such may have at least one separate high-effect zone that has its own cooling units such as cooling units 260 and 270, which have in between at least two racks such as racks 252 and 254.

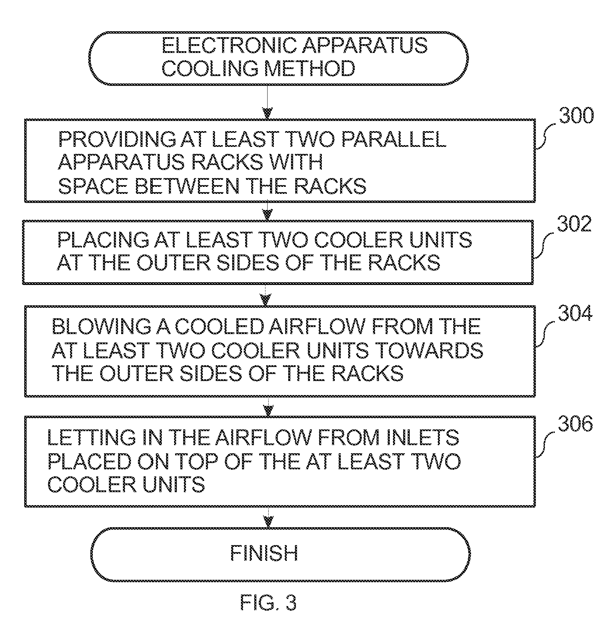

Figure 3 is a flow chart illustrating an apparatus rack cooling method in one embodiment of the invention.

At step 300 at least two parallel apparatus racks are provided. There is a space between the racks.

At step 302 at least two cooler units are placed at the outer sides of the apparatus racks.

At step 304 a cooled airflow is produced from the at least two cooler units towards the outer sides of the racks.

At step 306 the airflow from inlets placed on top of the at least two cooler units is obtained to the at least two cooler units.

Thereupon, the method is finished.

It is to be understood that the exemplary embodiments are for exemplary purposes, as many variations of the specific hardware used to implement the exemplary embodiments are possible, as will be appreciated by those skilled in the hardware art(s). For example, the functionality of one or more of the components of the exemplary embodiments can be implemented via one or more hardware devices.

All or a portion of the exemplary embodiments can be implemented by the preparation of application-specific integrated circuits or by interconnecting an appropriate network of conventional component circuits, as will be appreciated by those skilled in the electrical art(s).

While the present inventions have been described in connection with a number of exemplary embodiments, and implementations, the present inventions are not so limited, but rather cover various modifications, and equivalent arrangements, which fall within the purview of prospective claims.

It is obvious to a person skilled in the art that with the advancement of technology, the basic idea of the invention may be implemented in various ways. The invention and its embodiments are thus not limited to the examples described above; instead they may vary within the scope of the claims.

## Claims

1. A method for cooling a device mounted to an apparatus rack,
providing at least two parallel apparatus racks comprising at least one device mounted to said racks;
providing at least two cooling units on outer sides of both said at least two parallel apparatus racks, **characterized by**
directing first cooled airflows from both said at least two cooling units to respective outer sides of said at least two equipment racks wherein said airflows are substantially horizontal laminar airflows;
receiving second airflows to inlets provided on top of both said at least two cooling units, said second airflows conveying heat from said at least two equipment racks.

2. The method according to claim 1, **characterized by** the method further comprising:
providing a first cover to separate a first cool air space between a first equipment rack and a first cooling unit from the hot air space between the first equipment rack and the second equipment rack; and
providing a second cover to separate a second space between a second equipment rack and a second cooling unit from the hot air space between the first equipment rack and the second equipment rack.

3. The method according to claim 1, **characterized in that** the at least two cooling units comprise respective cooling battery that dissipates heat to coolant fluid.

4. The method according to claim 2, **characterized in that** inside the first or second apparatus rack the space surrounding a device mounted to the rack is hindered from air flow, thereby forcing the laminar airflow to pass through the device.

5. The method according to claim 1, **characterized by** arranging more than one cooling units to a row formation, arranging more than one apparatus racks to a row formation, said rows forming a cold aisle between cooling units and the apparatus racks and a hot aisle between two parallel apparatus racks.

6. A system for cooling a device mounted to an apparatus rack, comprising:
a first apparatus rack;
a second apparatus rack in parallel with said first apparatus rack;
at least one device mounted to said apparatus rack, **characterized by**
a first cooling unit is arranged in parallel with said first apparatus rack, said first cooling unit being configured to produce a substantially horizontal laminar cooled airflow towards outer side of said first apparatus rack, said first cooling unit comprising an inlet in the upper part for an airflow to be cooled; and
a second cooling unit is arranged in parallel with said second apparatus rack, said second cooling unit being configured to produce a substantially horizontal laminar cooled airflow towards outer side of said second apparatus rack, said second cooling unit comprising an inlet in the upper part for an airflow to be cooled.

7. The system according to claim 6, **characterized by** the first and the second cooling unit comprising a cooling battery that dissipates heat to a coolant fluid.

8. The system according to claim 6, **characterized in that** a distance between said first and second apparatus racks is between 800 mm and 1400 mm.

9. The system according to claim 6, **characterized in that** a distance between cooling unit and apparatus rack is between 800 mm and 1400 mm.

10. The system according to claim 6, **characterized by** the system further comprising:
a first cover to separate a first cool air space between a first equipment rack and a first cooling unit from the hot air space between the first equipment rack and the second equipment rack; and
a second cover to separate a second space between a second equipment rack and a second cooling unit from the hot air space between the first equipment rack and the second equipment rack.

11. The system according to claim 10, **characterized in that** the space surrounding a device mounted to the rack inside the first or second apparatus rack is hindered from air flow, thereby forcing the laminar airflow to pass through the device.

12. A system for cooling a device mounted to an apparatus rack, comprising:
a first cooling unit;
a first apparatus rack;
at least one device mounted to said apparatus rack, **characterized by**
said first cooling unit is arranged in parallel with said first apparatus rack placed at a distance allowing maintenance work in the area between the first cooling unit and the first apparatus rack,
said first cooling unit being configured to produce a substantially horizontal laminar cooled airflow, said airflow being evenly distributed over the side of first apparatus rack facing the first cooling unit.

13. The system according to claim 12, **characterized in that** the distance between the first cooling unit and the first apparatus rack is between 800 mm and 1400 mm.
